(19)

**Europäisches Patentamt**

**European Patent Office**

**Office européen des brevets**

(11) **EP 4 756 440 A1**

(12) **EUROPEAN PATENT APPLICATION**

(43) Date of publication:
**10.06.2026 Bulletin 2026/24**

(21) Application number: **24217928.1**

(22) Date of filing: **05.12.2024**

(51) International Patent Classification (IPC):
**G01R 27/26** (2006.01)     **G01R 31/64** (2020.01)
**G01R 31/40** (2020.01)

(52) Cooperative Patent Classification (CPC):
**G01R 31/64; G01R 27/2605;** G01R 31/40;
H02M 7/4835

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **GE Vernova Technology GmbH
5400 Baden (CH)**

(72) Inventors:
- **WAN, Jiqiang
  Stafford, ST16 1WS (GB)**
- **NOLAN, Andrew
  Stafford, ST16 1WS (GB)**
- **STOTT, Timothy
  Stafford, ST16 1WS (GB)**

(74) Representative: **Openshaw & Co.
8 Castle Street
Farnham, Surrey GU9 7HR (GB)**

(54) **METHOD AND SYSTEM FOR DETERMINING CAPACITOR DEGRADATION**

(57)     A method of determining submodule capacitor degradation. The method comprising the step of determining voltage change of at least one submodule capacitor during a control cycle whilst the at least one submodule is switched into a valve circuit and assigning the voltage change as $dV_{vsm}$. The method further comprising the step of determining average voltage change across all in-circuit submodules during said control cycle and assigning the average voltage change as $dV_{average}$. The method further comprising the step of determining relative capacitance of all in-circuit submodules by comparing $dV_{vsm}$ to the $dV_{average}$ of all in-circuit submodules.

The method may further comprise the step of determining capacitance deviation of all in-circuit submodules to quantify how much the capacitance of each in-circuit submodule deviates from the average voltage change $dV_{average}$ across all in-circuit submodules. The method may further comprise the step of comparing the determined capacitance deviation against a pre-defined threshold value to identify degraded in-circuit submodules. The method may further comprise step of filtering $dV_{vsm}$ and $dV_{average}$ or functions of them to achieve higher accuracy of the relative capacitance determination and capacitor degradation determination.

FIGURE 2

EP 4 756 440 A1

**Description**

FIELD OF THE INVENTION

The present invention relates to a method and system for determining capacitor degradation and more particularly, but not exclusively, to a method and system for real-time detection of capacitor degradation in voltage source convertor systems using indirect capacitance measurement.

BACKGROUND

Capacitance degradation refers to the decline in a capacitor's ability to store electrical charge. Over time, capacitors, particularly those used in high-power systems such as Voltage Source Converter (VSC) High Voltage Direct Current (HVDC) transmission systems, STATCOM (Static Synchronous Compensator) systems and systems based on modular multilevel converter, experience wear and tear.

Several factors can contribute to capacitor degradation, including thermal stress, voltage stress, aging, and environmental influences.

Thermal stress occurs when repeated heating and cooling cycles cause the material inside the capacitor to break down, leading to reduced capacitance. Voltage stress results from over-voltage conditions or continuous operation at high voltages, which accelerates the degradation of the dielectric materials within the capacitor. Aging refers to the natural reduction in effectiveness over time, as chemical and physical changes occur in the capacitor's materials. Environmental conditions such as humidity and vibration can also play a role in the physical deterioration of capacitors.

The consequences of capacitor degradation can include decreased energy storage capacity, increased internal resistance, temperature rise, and in extreme cases, catastrophic failure of the capacitor. In systems that rely on precise power modulation, such as VSC HVDC and STATCOM systems, capacitor degradation can lead to instability, inefficiency, and equipment failure.

It is therefore critical to monitor capacitor degradation as, in VSC and STATCOM systems, submodule capacitors play a critical role in maintaining stable voltage waveforms for power conversion between AC and DC networks. Any significant loss in capacitance may affect the ability of the system to generate the required waveforms accurately, leading to power quality issues, increased losses, and potential failures.

Early detection of capacitance degradation is therefore needed. This enables predictive maintenance, allowing operators to replace degraded components before they fail. This improves system reliability, reduces downtime, and minimizes maintenance costs.

There are several known methods to monitor capacitance in submodules, for example directly measuring the capacitance of submodule capacitors by taking them offline for testing. Specialised equipment can measure the charge and discharge cycles, providing an accurate capacitance reading. However, this method requires taking the system out of service, resulting in downtime. It is also labour-intensive and costly, making it impractical for continuous monitoring in HVDC and STATCOM systems.

There are also known methods to directly monitor on-line submodule capacitance using valve current measurement or to measure submodule capacitance while the submodule is not in the valve circuit. Such methods are considered less accurate. One example of a known method is to measure and integrate valve current to calculate electrical charge, and then measure submodule voltage change. Capacitance can then be calculated. Another example of a known method is to switch a redundant submodule out of a valve circuit and discharge the submodule with a known current over a period. The capacitance can be calculated using the voltage change and the known current.

Capacitor degradation is often accompanied by a temperature rise due to increased internal losses (increased resistance) or higher switching rate. Thermal sensors can be used to monitor this temperature increase, allowing for an indirect assessment of degradation. However, temperature changes can be caused by many factors other than capacitance degradation, leading to false positives. Furthermore, this approach only detects issues when degradation is already advanced, leaving limited time for preventive actions.

As capacitors degrade, their resistance typically increases. Monitoring changes in resistance can provide insight into the health of capacitors. However, resistance measurement in a working system is complex, as resistance fluctuates due to load conditions and other factors. This method often requires additional hardware and complex calibration, which increases both system costs and complexity.

Capacitors can be tested for degradation during scheduled maintenance by removing them from the circuit and measuring their electrical properties. However, this method is intrusive, and, as with direct measurement, requires the system to be taken offline. It is not suitable for real-time continuous monitoring and is more likely to miss early signs of degradation.

Many of the known methods are therefore disruptive and can lead to costly downtime. Methods like thermal or resistance monitoring, may not detect degradation early enough to prevent failure, and their accuracy can be affected by other operational factors. Advanced equipment for real-time monitoring adds significant cost and complexity, making it difficult to implement widely. Additionally, offline testing only provides a snapshot of the capacitor's condition at the time of testing, potentially missing early-stage degradation that occurs between maintenance intervals.

Given these limitations, there is a clear need for a more effective, low-cost, and non-intrusive method for continuously monitoring capacitor degradation in VSC and STATCOM systems. An improved solution would therefore allow for real-time detection of degradation without the need for additional hardware or system downtime and may detect small changes in capacitance early enough to predict failures and allow for timely maintenance, ensuring system stability and reliability.

The method described herein tends to address these issues by providing an indirect, on-the-fly measurement of capacitance. The method may operate continuously under normal system conditions, without disrupting operation or requiring expensive additional hardware. By accurately detecting early-stage capacitor degradation, higher reliability and lower maintenance costs are ensured - increasing operational efficiency for VSC HVDC and STATCOM systems.

SUMMARY OF THE INVENTION

In an aspect, there is provided a method of monitoring submodule capacitor degradation as defined in the appended independent method claim. Further preferable steps of the method of monitoring submodule capacitor degradation are defined in the appended dependent apparatus claims.

According to a further aspect there is provided a system for monitoring submodule capacitor degradation as defined in the appended independent system claim. Further preferable features of the system for monitoring submodule capacitor degradation are defined in any appended dependent system claims.

The monitored submodules may be part of either a VSC HCDC, STATCOM system or any other modular multilevel converter system, and or each of the steps may be performed in real-time, i.e. whilst the system is operating, and or wherein the step of determining capacitance relative deviation. This tends to enable real-time monitoring of submodules within a VSC HVDC, STATCOM system or any other modular multilevel converter system while the system is actively operating. This tends to mean that potential issues with capacitor degradation can be detected immediately, without needing to shut down the system for inspection. Additionally, determining relative capacitance deviation, for example as a percentage, may provide a clear and standardised measure for assessing the health of the capacitors, enabling more precise maintenance and reducing the risk of unexpected system failures.

The steps of determining submodule capacitor degradation may also be performed offline (i.e. not in real-time). Offline monitoring of capacitor degradation tends to allow for assessment of capacitor health without the constraints introduced by real-time system operation. Offline monitoring may enable the detection of subtle degradation patterns that might be missed during online monitoring.

The step of measuring voltage change $dV_{vsm}$ of at least one submodule capacitor during a control cycle may comprise $V_{vsm}(t_2) - V_{vsm}(t_1)$, wherein $V_{vsm}(t_1)$ and $V_{vsm}(t_2)$ are the voltage readings at the beginning and end of the control cycle, respectively. This step tends to enable precise tracking of voltage changes in submodule capacitors during a control cycle by comparing voltage readings at the beginning and end of the cycle, thus providing an accurate way to assess capacitor performance in real-time. The step may ensure timely and efficient monitoring without additional complex hardware, improving system reliability and maintenance planning. When there is only one submodule in the valve circuit it is not practical to work out the relative capacitance because $dV_{vsm} = dV_{average}$.

The step of determining average voltage change $dV_{average}$ across all in-circuit submodules may comprise $\frac{1}{N}\sum_{i=1}^{N} dV_{vsm,i}$ wherein $N$ is the number of submodules in the circuit, and $dV_{vsm,i}$ is the voltage change for the $i$ th submodule during the control cycle. This step tends to smooth out any individual anomalies or outliers, which helps in identifying trends in submodule health without being skewed by a single faulty unit.

The step of determining relative capacitance of all in-circuit submodules may comprise using $\frac{C_{vsm}}{C_{average}} = \frac{dV_{average}}{dV_{vsm}}$ wherein $C_{vsm}$ is the capacitance of the in-circuit submodule, $C_{average}$ is the average capacitance of all in-circuit submodules, $dV_{vsm}$ is the voltage change of the in-circuit submodule, and $dV_{average}$ is the average voltage change of all in-circuit submodules. This tends to enable the relative capacitance of each in-circuit submodule to be determined in relation to the average capacitance of all in-circuit submodules. By comparing the voltage change of an individual in-circuit submodule to the average voltage change of all in-circuit submodules, the system may quickly and efficiently identify capacitors that are deviating from the norm.

The step of determining capacitance deviation of all in-circuit submodules may comprise performing $\left(\frac{dV_{average}}{dV_{vsm}} - 1\right) \times 100\%$ or $\left(1 - \frac{dV_{vsm}}{dV_{average}}\right) \times 100\%$. Such a step tends to provide a straightforward and quantifiable way to assess the health of each submodule by calculating the percentage deviation of its capacitance from the system average.

Advantageously the values determined by performing the above-mentioned method may be stored for historical tracking. This tends to enable long-term monitoring and trend analysis of submodule performance and operators may identify patterns of degradation, predict potential failures, and make informed maintenance decisions before problems arise.

The aforementioned method may further comprise the step of applying digital filtering to $dV_{vsm}$ and or $dV_{average}$. This tends to help reduce noise and improve the accuracy of relative capacitance measurements, thus ensuring more reliable and precise detection of capacitance changes in the submodules. Over time all the submodules will have been in-circuit, thus relative capacitance of each submodule capacitor will be measured.

The filter applied may be as follows:

$$Filter\left(\frac{dV_{average}}{dV_{vsm}}\right)$$

This may smooth out any noise or fluctuations in the voltage data, thus making the comparison between average and individual submodule voltage changes more accurate.

Alternatively, the filter applied may be:

$$\frac{Filter\left(dV_{average}\right)}{Filter\left(dV_{vsm}\right)}$$

This may enable more precise and independent noise reduction in both the average and individual submodule voltage measurements. The step may therefore address distinct noise characteristics in each signal by filtering each component individually. This may lead to more accurate capacitance deviation calculations.

In a further alternative, the filter may be:

$$\left(\frac{Filter\left(dV_{average}\right)}{Filter\left(dV_{vsm}\right)} - 1\right) \times 100\%$$

Such a step may provide a more refined and accurate percentage-based deviation calculation, while also minimising noise in both the average and individual voltage signals.

Preferably, when a submodule is not in the valve circuit during a control cycle, the filter operation may be paused for that cycle. Pausing the filter operation when a submodule is not in the valve circuit during a control cycle tends to prevent unnecessary or data processing based on invalid input. As such, only relevant and valid voltage data may be used for filtering and capacitance deviation calculations. By pausing the filter, the system may avoid less accurate results, which leads to more efficient system operation and better decision-making for maintenance.

Control cycles wherein the number of in-circuit submodules is below a threshold value may be excluded from the analysis. This step tends to prevent inaccurate or unreliable analysis due to insufficient data, for example, when too few submodules are in the circuit, the calculated averages and deviations may not accurately reflect the overall condition of the system. Similarly, the control cycles wherein $dV_{average}$ does not exceed a threshold value may be excluded from the analysis to ensure that only meaningful voltage changes are considered. When the average voltage change is too small, it may not provide sufficient information for accurate assessment of the condition of the submodules.

A system for executing the method discussed above may comprise at least one submodule capacitor and associated valve circuit, a voltage sensor configured to measure the voltage changes for the at least one submodule capacitor, a control system configured to switch the at least one submodule into the valve circuit, a processor configured to execute the method steps of determining average voltage change, relative capacitance, and capacitance deviation in real-time, and the valve circuit may comprise the at least one submodule capacitor and is configured to switch the at least one submodule capacitor into and out of said valve circuit as managed by the control system.

Such a system tends to integrate components (submodule capacitors, voltage sensors, control systems, and processors) required to perform real-time monitoring and analysis of submodule health. The voltage sensor may continuously measure voltage changes, while the control system may switch submodules in and out of the valve circuit. The processor may calculate average voltage changes, relative capacitance, and capacitance deviation in real-time. This tends to enable immediate detection of submodule degradation. The system and associated method disclosed herein tends to improve reliability, reduce manual intervention, and enable proactive maintenance, thus minimising downtime and helping to ensure efficient operation.

Within the scope of this application, it is expressly intended that the various aspects, embodiments, examples, and alternatives set out in the preceding paragraphs, and the claims and/or the following description and drawings, and in particular the individual steps and/or features thereof, may be taken independently or in any combination. That is, all embodiments and all steps and features of any embodiment can be combined in any way and/or combination, unless such features are incompatible.

BRIEF DESCRIPTION OF THE DRAWINGS

Figure 1 is a graph of the percentage error of submodule capacitances, wherein the graph is produced by simulating the method disclosed herein and shows the capacitance deviation of a valve having 325 submodules; and

Figure 2 is a graph of the percentage error of submodule capacitances, wherein the graph is produced by simulating the method disclosed herein and shows the capacitance deviation of a valve having 325 submodules, with 1 submodule having -5% capacitance deviation.

DETAILED DESCRIPTION

An embodiment of the present invention discloses a method of indirectly measuring the capacitance of one or more submodule capacitors, and detecting deviations that indicate degradation of said capacitor. The method may be performed in real-time, i.e. whilst the system is operating, or offline based on data collected while the system was operating.

Submodules, which contain the capacitors as energy storage devices, are connected in series or parallel within the valve circuit (converter valve) of the VSC HVDC, STATCOM system or systems based on modular multilevel converter. Each submodule comprises one or more capacitors and semiconductor switches (e.g., IGBTs) to control the connection of the submodule to the circuit. The submodules are switched in and out of the valve circuit to generate the required AC/DC waveforms. The capacitor(s) of each in-circuit (connected) submodule may charge or discharge as it is connected and disconnected by the control system. The semiconductor switches, such as IGBTs, control the connection of each submodule into the circuit, allowing the capacitor to charge or discharge as needed. This switching mechanism tends to ensure that energy is stored and released in a controlled manner, forming the AC/DC waveforms required for system operation.

The valve circuit consists of multiple submodules connected in series, forming a chain. These chains are arranged to facilitate the conversion between AC and DC power. The valve circuit manages the flow of power by switching submodules in and out based on the control signals received from the control system. This tends to ensure that the same current passes through all connected (in-circuit) submodules, allowing for consistent charges or discharges across the capacitors.

The modular structure of the valve circuit allows for redundancy and scalability, tending to ensure that the system can continue operating effectively even if one or more submodules degrade or are disconnected for maintenance. This tends to enhance the overall reliability and flexibility of the system.

Voltage sensors or probes connect to the capacitor(s) of each submodule to monitor voltage changes in real-time. These voltage sensors are connected to the control system, allowing continuous or periodic data flow. The voltage measurement system captures the voltage across each capacitor during each control cycle. This data is then transmitted to the control system for analysis. Precise placement of voltage sensors is critical for accurate data acquisition. These sensors are integrated directly into each submodule to provide real-time voltage data.

The control system is centrally connected to the valve circuit, the voltage measurement system, and a digital processor, wherein the digital processor is a processing unit integrated within the VSC HVDC, STATCOM system or systems based on modular multilevel converter that executes control algorithms - performing calculations and managing real-time data processing. The digital processor may be a microcontroller, digital signal processor (DSP), programmable logic controller (PLC), field-programmable gate array (FPGA), or the like. Microcontrollers tend to be suitable for simpler or smaller-scale systems; DSPs or FPGAs tend to be used in larger, high-speed systems where high processing power and speed are necessary; PLCs are commonly used in industrial settings, where rugged, reliable control is needed. The digital processor interacts dynamically with the control system by, for example, executing control algorithms, adjusting thresholds, and excluding unreliable cycles based on real-time conditions. This adaptive functionality may allow the system to respond quickly and accurately to changing operating states.

The control system is configured to serve as the central hub, coordinating the switching of submodules and collecting voltage data. The control system executes algorithms (described in more detail below) needed to calculate

voltage changes ($dV_{vsm}$), average voltage change ($dV_{average}$), and relative capacitance. The control system also determines which submodules to switch in or out based on the operating requirements of the system. The control system is also configured to apply digital filters to voltage data for smoothing and accuracy.

The filters tend to be software-implemented within the digital processor or microcontroller and integrated into the control algorithms. The filters are configured to process the voltage data from the voltage sensors, i.e., smooth out fluctuations and remove noise to ensure more accurate measurements. The filtered data is then used for further calculations.

The choice of filter, for example IIR (Infinite Impulse Response), FIR (Finite Impulse Response), MAF (Moving Average Filter), AF (Average Filter), accumulator or other, may be adapted based on the specific requirements of the system, for example, response time, processing power availability, and noise characteristics. MAF or AF, for example, may be preferred in environments with consistent voltage variations because it is typically simple and stable.

To account for environmental factors that might influence capacitor performance or capacitor voltage measurement performance, additional sensors (e.g., temperature or humidity sensors) may be integrated. This tends to differentiate between deviations caused by environmental conditions and those resulting from actual capacitor degradation, providing more accurate assessments.

A data storage system tends to be linked to the digital processor and control system. It may be an integrated component of the control system or an external database connected via a communication interface. The data storage system stores historical data on voltage changes, relative capacitance values, and deviations, allowing operators to review past data and set up predictive maintenance alerts.

A threshold setting mechanism may be part of the control software. This may interface with the digital processor. It may also be connected to a user interface for configuring thresholds. This tends to help operators set and adjust the thresholds for capacitance deviation. When the deviation exceeds the threshold, the control system flags the affected submodule for maintenance.

Thresholds for capacitance deviation may be based, for example, on historical data, manufacturer specifications, and system tolerance levels. By using such an approach to set these thresholds, the system can accurately detect degradation tailored to the specific characteristics of the capacitors and operating conditions.

An interface for excluding unreliable submodule voltage readings, excluding submodule voltage change readings and excluding unreliable control cycles may be integrated within the control system software. This can analyse the control cycles based on conditions (e.g., number of in-circuit submodules with good quality of voltage change readings or their average voltage change magnitude) and communicate with the digital processor. The system may then use pre-set rules to exclude control cycles that do not meet reliability criteria. This tends to result in only high-quality data being used for calculations.

The control system, digital processor, and data storage system are then connected to a communication system which enables real-time monitoring and alerts for maintenance personnel. Such a system may also support remote parameter adjustments, such as changing thresholds or reviewing historical data for analysing trends.

With regard to the method of monitoring the voltage changes in submodule capacitors, the steps are as follows: Step 1: Measure individual voltages and calculate voltage change for each submodule during each control cycle.

When the system (either a VSC HVDC, STATCOM system or system based on modular multilevel converter) is running, the submodules in the converter are switched into or out of the valve circuit. The submodules, switched into the valve circuit (in-circuit), store energy in capacitors and are charged or discharged by the same valve current. During each control cycle, the voltage across the capacitors changes as a result of this charging or discharging. The voltage change for each in-circuit submodule capacitor(s) ($dV_{vsm}$) is calculated and recorded.

Therefore, step 1 is to measure and calculate the voltage change for each submodule capacitor(s) during a control cycle:

$$dV_{vsm} = V_{vsm}(t_2) - V_{vsm}(t_1)$$

wherein:

$dV_{vsm}$ is the voltage change for the in-circuit submodule during a control cycle, and
$V_{vsm}(t_1)$ and $V_{vsm}(t_2)$ are the voltage readings at the beginning and end of the control cycle, respectively.

The valve current charges or discharges each submodule capacitor(s), and the change in voltage is proportional to the inverse of the submodule capacitance, i.e. submodules with lower capacitance will experience a larger voltage change for the same current in the control cycle, while those with higher capacitance will see a smaller voltage change. By monitoring the voltage change in each submodule, the method captures data that can later be used to estimate submodule capacitance indirectly.

Step 2: Calculate the average voltage change across all submodules for normalisation.

In the same control cycle, the average submodule voltage change ($dV_{average}$) across all in-circuit submodules is calculated. This average serves as a reference for detecting deviations in individual submodules.

Therefore, step 2 is to compute the average voltage change across all in-circuit submodules during the same control cycle:

$$dV_{average} = \frac{1}{N} \sum_{i=1}^{N} dV_{vsm,i}$$

wherein:

$dV_{average}$ is the average voltage change across all in-circuit submodules during the control cycle,
$N$ is the number of submodules in the valve circuit during the control cycle, and
$dV_{vsm,i}$ is the voltage change for the $i$ th in-circuit submodule during the control cycle.

This calculation creates a baseline for comparing individual submodule performance and detecting deviations.

Step 2 normalises the voltage changes across all in-circuit submodules, allowing comparisons to be made between individual submodule behaviour and the overall behaviour of the system. It tends to enable the detection of outliers or submodules with capacitance deviations.

Step 3: Determine the relative capacitance by comparing individual and average voltage changes in a control cycle.

This is to calculate the relative capacitance of the individual in-circuit submodules. The relative capacitance of each individual in-circuit submodule is determined by comparing its voltage change ($dV_{vsm}$) to the average voltage change ($dV_{average}$), i.e.:

$$\frac{C_{vsm}}{C_{average}} = \frac{dV_{average}}{dV_{vsm}}$$

wherein:

$C_{vsm}$ is the capacitance of the in-circuit submodule during the control cycle
$C_{average}$ is the average capacitance of all in-circuit submodules during the control cycle
$dV_{vsm}$ is the voltage change of the in-circuit submodule during the control cycle
$dV_{average}$ is the average voltage change of all in-circuit submodules during the control cycle.

The above defines a direct relationship between the voltage change of each in-circuit submodule and the average. This ratio enables the system to estimate how much the capacitance of each in-circuit submodule differs from the average capacitance of all in-circuit submodules. By comparing the individual in-circuit submodule voltage change with the average, the system can determine whether a particular submodule's capacitance is lower or higher than expected. A higher-than-average voltage change indicates lower capacitance (indicating potential degradation), while a lower-than-average voltage change indicates higher capacitance (indicating less degradation).

Step 4: Calculate the capacitance deviation as a percentage to quantify degradation.

The next step is to calculate capacitance deviation. This is calculated as a percentage, as follows:

$$Capacitance\ Deviation = \left( \frac{dV_{average}}{dV_{vsm}} - 1 \right) \times 100\%$$

or:

$$Capacitance\ Deviation = \left( 1 - \frac{dV_{vsm}}{dV_{average}} \right) \times 100\%$$

wherein:

$dV_{vsm}$ is the voltage change of the in-circuit submodule in the control cycle

$dV_{average}$ is the average voltage change of all in-circuit submodules in the control cycle.

This gives a percentage-based measurement of how much the capacitance of a submodule deviates from the system average. A deviation threshold can be set, and if a submodule exceeds that threshold, it can be flagged for potential degradation. The percentage deviation is proportional to the amount of degradation experienced by the capacitor.

By converting the voltage ratio into the above format, this step enables the system to quantify how much the capacitance has deviated from the norm. Using this deviation percentage, operators can set limits for acceptable deviation and determine when maintenance or capacitor replacement is needed.

Alternatively, the following formula can be used to calculate capacitance deviation:

$$\left(1 - \frac{dV_{vsm}}{dV_{average}}\right) \times 100\%$$

The formula is arguably more simple and intuitive, making it easier to implement in digital circuits as it only requires a single division and a subtraction operation. The formula therefore uses less computing power.

The capacitance of each in-circuit submodule is inversely related to the voltage change it experiences during the control cycle. The submodule with higher capacitance will exhibit smaller voltage changes. The submodule with lower capacitance will exhibit larger voltage changes for the same current.

To calculate capacitance deviation, step 4 compares the voltage change of each in-circuit submodule to the system average voltage change of all in-circuit submodules in the control cycle. The deviation indicates how much the capacitance of a particular in-circuit submodule differs from the baseline established by the average voltage change across all in-circuit submodules.

In step 4, therefore, in-circuit submodule capacitance is indirectly measured. Voltage changes across submodules are measured, and from those voltage changes, the relative capacitance values are inferred. As mentioned above, capacitance and voltage change of in-circuit submodules are inversely related. Therefore, the above method uses the average of the voltage changes of in-circuit submodules to assess capacitance deviations.

With regard to storing any calculated values, the voltage change, average voltage change, relative capacitance, and capacitance deviation values described above may be stored for use.

For example, for real-time monitoring, capacitance deviation may be calculated and used on the fly, without long-term storage. Capacitance deviation is then used to flag submodules for maintenance or monitoring based on whether the deviation exceeds a certain threshold at a given point in time. This is explained in detail below. Alternatively, the calculated capacitance deviation may be stored in a data storage system. This would enable trends to be tracked over time as by storing deviations over multiple control cycles, operators can observe the change in performance of a submodule. Such a method tends to enable future failures to be predicted. Furthermore, stored deviation data may be used to review past system performance and therefore assess the long-term reliability of submodules. This tends to enable an operator to make informed decisions about maintenance schedules and the like.

In order that historical tracking is possible, the system may record capacitance deviation values, system average values (such as average voltage change for each control cycle), timestamped records (e.g. each deviation may be linked to a specific time or cycle to enable trend analysis), and threshold breaches (e.g. when capacitance deviation exceeds pre-defined thresholds a log is made to trigger a maintenance alert).

Step 5: Compare deviation values against a threshold to identify submodules requiring maintenance.

The next step is to continuously compare the calculated capacitance deviation against a pre-defined threshold.

For example:

$$\textit{Flag submodule IF } |\textit{capacitance deviation}| > \textit{threshold}$$

This step is to compare the previously computed capacitance deviation with a threshold value and, as appropriate, flag submodules for degradation. Continuous monitoring and comparison against a set threshold enables capacitor degradation to be detected over time. This step therefore helps the system to identify which submodules require maintenance based on their degradation levels.

In summary, the method of monitoring capacitor degradation disclosed herein comprises at least the steps of: measuring the voltage change for each in-circuit submodule capacitor during a control cycle; calculating the average voltage change across all in-circuit submodules during the control cycle; calculating the relative capacitance for each submodule by comparing the voltage change of said submodule to the average voltage change of the in-circuit submodules; calculating the capacitance deviation as a percentage to quantify how much the capacitance of the submodule deviates from the system average; and comparing the calculated capacitance deviation against a pre-defined threshold value. The method can be performed in real-time and to monitor capacitor degradation in a VSC HVDC, STATCOM system or system based on modular multilevel converter. By continuously measuring voltage changes for each in-circuit submodule capacitor(s) and calculating relative capacitance deviations compared to the system average, the method tends to quantify and identify submodules with degraded capacitance. This allows for proactive maintenance by flagging submodules whose capacitance deviation exceeds a pre-defined threshold, thereby enhancing system reliability and preventing failures without requiring system downtime or additional hardware.

To improve the accuracy of the measurements, the step of applying digital filtering to the voltage change data may be performed. This can be done using various types of filters such as IIR (Infinite Impulse Response), FIR (Finite Impulse Response), AF (Averaging Filter), MAF (Moving Average Filter) or Accumulator. Filtering is advantageous when dealing with fluctuating current and voltage conditions, imperfect timing and accuracy of submodule voltage measurements, or in control cycles with noisy data.

Filters are applied to both $dV_{vsm}$ and $dV_{average}$ so that the ratio between the two is smoothed out and provides a more reliable estimate of relative capacitance. Digital filtering removes noise and inconsistencies in the voltage readings, leading to more accurate capacitance estimations. By applying filters to both the individual and average voltage changes, the method can avoid skewing the results due to outlier values or transient effects in specific control cycles. Filtering can also ensure that small fluctuations do not result in false positives for capacitor degradation.

The filters may be applied as follows:

$$Filter\left(\frac{dV_{average}}{dV_{vsm}}\right)$$

In this approach, the filter is applied directly to the ratio of the average voltage change ($dV_{average}$) of all in-circuit submodules to the individual in-circuit submodule voltage change ($dV_{vsm}$). This smoothed ratio gives a more accurate estimate of relative capacitance.

Or:

$$\frac{Filter\left(dV_{average}\right)}{Filter\left(dV_{vsm}\right)}$$

Alternatively, the filter can be applied separately to both the average and individual voltage changes before taking their ratio. This provides a similarly smoothed result. Note: each submodule needs two filters. The filter for the average voltage changes cannot be shared between submodules.

With regard to capacitance deviation, the following formula is applied:

$$\left(\frac{Filter\left(dV_{average}\right)}{Filter\left(dV_{vsm}\right)} - 1\right) \times 100\%$$

or

$$\left(1 - \frac{Filter\left(dV_{vsm}\right)}{Filter\left(dV_{average}\right)}\right) \times 100\%$$

This applies filtering before calculating the deviation percentage, ensuring that any fluctuations in the voltage measurements are minimised.

Other variations of filtering the ratio or filtered difference are as follows:

$$Filter\left(\frac{dV_{average}}{dV_{vsm}} - 1\right) \times 100\%$$

or

$$\left(Filter\left(\frac{dV_{average}}{dV_{vsm}}\right) - 1\right) \times 100\%$$

or

$$Filter\left(1 - \frac{dV_{vsm}}{dV_{average}}\right) \times 100\%$$

or

$$\left(1 - Filter\left(\frac{dV_{vsm}}{dV_{average}}\right)\right) \times 100\%$$

These illustrate that applying the filter at different points in the calculation can still yield accurate results. The goal is to minimise the impact of noise and imperfect submodule voltage measurements and ensure consistent measurements of relative submodule capacitance and degradation.

When a submodule is not in the valve circuit during a control cycle (i.e. it is not actively participating in the power conversion process), the filter operation is paused for that cycle for the submodule. This ensures that only valid, meaningful data is used for filtering, improving the overall accuracy of the filtered results.

To further improve accuracy, the in-circuit submodules reporting voltage measurement with low quality may be excluded. For example, during the first control cycle the submodules are switched into the valve circuit, the voltage measurement may be less accurate than the following control cycles. So, this 'first control cycle' may be excluded for average voltage change calculation and the relative capacitance determination.

To further improve accuracy, the method may exclude certain control cycles from the analysis. Control cycles where the number of submodules connected to the valve circuit is insufficient are excluded from the analysis. If there are too few submodules, the average voltage change calculation ($dV_{average}$) may not be representative, leading to inaccurate capacitance measurements. By excluding these cycles, the system focuses only on conditions where the data is reliable.

Also, control cycles with minimal voltage change may be excluded. If the average voltage change ($dV_{average}$) is too small (i.e., near zero), it may indicate low current flow or minimal activity in the circuit, making the voltage data less reliable for accurate capacitance assessment. Such cycles are excluded to prevent inaccuracies, ensuring that only cycles with sufficient voltage change (and therefore meaningful data) are used for analysis.

The steps of filtering and excluding certain control cycles and unreliable voltage measurements of in-circuit submodules therefore collectively improve the accuracy of the method by applying digital filters to smooth out fluctuations and noise in the voltage data and excluding control cycles that are not representative or lack sufficient data. This tends to ensure that only reliable and high-quality data is used, leading to more precise and consistent detection of capacitor degradation.

The method enables continuous, real-time monitoring of capacitor health, offering a significant advantage over traditional offline testing methods and other methods. This capability tends to ensure that any degradation is detected promptly, allowing for immediate corrective action without interrupting system operation.

Furthermore, the method is scalable and can be adjusted for different sizes and types of VSC HVDC, STATCOM systems and other systems based on modular multilevel converter. Whether deployed in smaller installations or large-scale power conversion systems, the system can be adapted to meet the specific monitoring requirements of each setup.

In addition to the above, the control system may integrate a user interface or software dashboard, providing operators with a simple way to monitor system status, view real-time data, and adjust thresholds or settings. Such a user-friendly interface enhances the practicality of the method in operational environments, which can mean that operators can respond swiftly to any detected anomalies.

It will also be understood that calibration or periodic calibration of voltage sensors may be necessary to maintain accuracy over time. Ensuring that the sensors are calibrated according to manufacturer specifications can help prevent drift and maintain the reliability of the voltage measurements.

The aforementioned method not only detects capacitor degradation but can also enhance the overall reliability of the VSC HVDC, STATCOM systems or system based on modular multilevel converter. By enabling proactive maintenance, the method described herein can result in stable power delivery and reduced downtime, thus improving the long-term stability of the system. The method is also designed to integrate seamlessly into existing VSC HVDC, STATCOM systems or system based on modular multilevel converter without the need for significant hardware modifications, making it a cost-effective solution for enhancing system reliability.

In addition to the above, it should also be noted that the absolute submodule capacitance may be determined by performing the following additional steps:

- (A) Measure the actual capacitance of one or more submodules during maintenance.
- (B) Calculate the absolute capacitance for all submodules using their relative capacitances and the known capacitance value from step (A).

Furthermore, it should also be noted that after performing the method steps disclosed to determine submodule capacitor degradation as well as flagging submodules with significant deviations from the average capacitance for further investigation or maintenance, one or more alert may trigger to notify to an operator that immediate action or closer monitoring of flagged submodules is required. Maintenance planning may also take place such as scheduling inspections, repairs, or replacements for degraded submodules based on the detected deviations. Historical data may also be updated for long-term monitoring and predictive maintenance planning, such as using the recorded relative capacitance values to assess the ongoing health of capacitors. Energy supplied to the flagged module may also be reduced, to reduce the strain on said module and prevent complete failure before further action can be taken. These actions tend to maintain system reliability and efficiency while minimising downtime and unplanned failures.

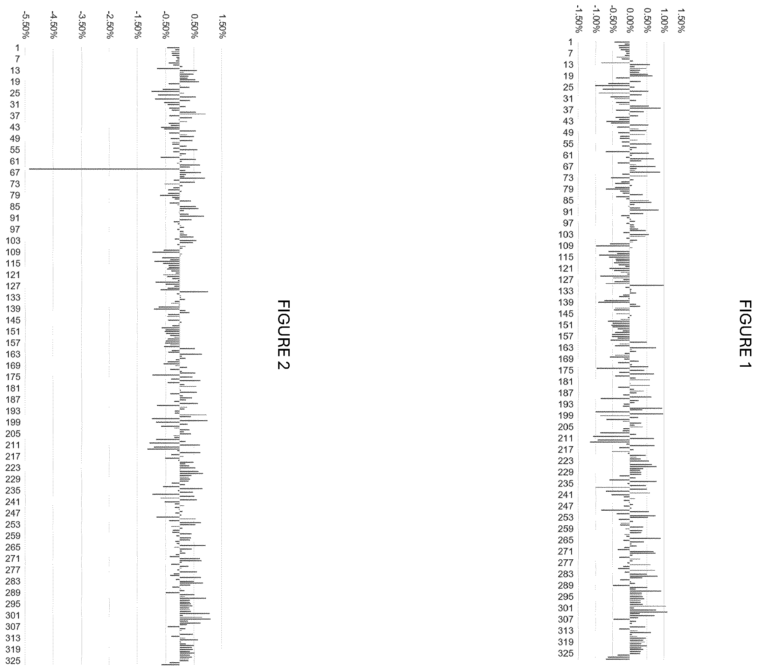

The method disclosed herein has been simulated and the results are shown in Figures 1 and 2.

In the first simulation, shown in Figure 1, a valve having 325 submodules was used. The percentage deviation of submodule capacitances stays within a tolerance of $\pm 1.5\%$. The error of the deviation determination is within 0.5% in the simulation with a typical mechanism and accuracy of acquisition of submodule voltage readings.

In the second simulation, shown in Figure 2, a valve having 325 submodules with 1 submodule having a -5% deviation in its capacitance was used. The degraded submodule can be easily seen as an outlier result against the other submodule capacitances which stay within a tolerance of $\pm 1.5\%$.

The simulation in Figure 1 demonstrates that the percentage deviation of submodule capacitances remains within a tolerance of $\pm 1.5\%$. This illustrates the high level of accuracy and reliability of the method under normal operating conditions. By maintaining such tolerances across a large number of submodules, it can be concluded that the method disclosed herein tends to consistently monitor capacitor performance without producing significant false positives or inaccuracies, which is essential for large-scale systems like VSC HVDC, STATCOM or system based on modular multilevel converter.

In Figure 2, the simulation introduces a submodule with a -5% capacitance deviation. This tends to demonstrate that the method can be successfully used to detect even small levels of degradation because the degraded submodule is easily identified as an outlier against the other submodule capacitances, which remain within the $\pm 1.5\%$ tolerance. Effective detection of capacitance deviation highlights the capability of the method to identify submodules with abnormal capacitance quickly and accurately. The simulation tends to show that degraded submodules can be easily flagged for maintenance, preventing potential failures, and ensuring the system continues to operate reliably.

The second simulation also tends to demonstrate the robustness of the method in handling outliers. One submodule shows significant degradation, but the method accurately analyses the remaining submodules without being affected by the degraded submodule. This tends to show that the method can manage large populations of submodules effectively and isolate issues without disrupting the overall system performance. The ability to maintain accuracy in systems with hundreds of submodules supports the view that the method is robust and reliable.

Additionally, both simulations tend to demonstrate the scalability of the method. With 325 submodules used in the simulation, the method tends to show it can handle large numbers of submodules without sacrificing accuracy or precision. Scalability is crucial for real-world applications because large-scale systems are common. By simulating the method using 325 submodules the method is validated as suitable for high-voltage power systems where monitoring the performance of numerous components is necessary.

The results of the simulations shown in Figures 1 and 2 also highlight how the method tends to be practically useful in maintaining the system. Figure 2 shows that the method clearly identifies the degraded submodule. This enables operators to implement proactive maintenance strategies and address degradation before it causes system failure. As discussed above, such early fault detection minimises downtime, extends the lifespan of components, and ensures continuous system reliability. The simulations validate the practicality and reliability of the method and demonstrate that the method can detect capacitance deviations while maintaining accuracy and scalability in large systems. This supports the view that the method is suitable for effective implementation in real-world power systems.

The simulated values used to generate the graph shown in Figure 1 and Figure 2 are provided for completeness:

| Simulated Deviations of Submodule Capacitances | | | | | |
|---|---|---|---|---|---|
| Submodule Index | Deviation (Figure 1) | Deviation (Figure 2) | Submodule Index | Deviation (Figure 1) | Deviation (Figure 2) |
| 1 | -0.0037 | -0.0037 | 163 | 0.0073 | 0.0073 |
| 2 | -0.0022 | -0.0022 | 164 | 0.0000 | 0.0000 |
| 3 | -0.0037 | -0.0037 | 165 | 0.0015 | 0.0015 |
| 4 | -0.0029 | -0.0029 | 166 | -0.0015 | -0.0015 |
| 5 | -0.0015 | -0.0015 | 167 | -0.0022 | -0.0022 |
| 6 | 0.0007 | 0.0007 | 168 | -0.0074 | -0.0074 |
| 7 | -0.0007 | -0.0007 | 169 | 0.0007 | 0.0007 |
| 8 | -0.0007 | -0.0007 | 170 | 0.0029 | 0.0029 |
| 9 | -0.0029 | -0.0029 | 171 | -0.0037 | -0.0037 |
| 10 | -0.0037 | -0.0037 | 172 | 0.0000 | 0.0000 |
| 11 | 0.0037 | 0.0037 | 173 | 0.0044 | 0.0044 |
| 12 | -0.0052 | -0.0052 | 174 | -0.0089 | -0.0089 |
| 13 | 0.0044 | 0.0044 | 175 | 0.0058 | 0.0058 |
| 14 | 0.0022 | 0.0022 | 176 | -0.0022 | -0.0022 |
| 15 | 0.0058 | 0.0058 | 177 | 0.0080 | 0.0080 |
| 16 | 0.0022 | 0.0022 | 178 | -0.0029 | -0.0029 |
| 17 | 0.0029 | 0.0029 | 179 | 0.0022 | 0.0022 |
| 18 | 0.0044 | 0.0044 | 180 | 0.0087 | 0.0087 |
| 19 | 0.0073 | 0.0073 | 181 | -0.0015 | -0.0015 |
| 20 | -0.0022 | -0.0022 | 182 | 0.0007 | 0.0007 |
| 21 | 0.0007 | 0.0007 | 183 | 0.0080 | 0.0080 |
| 22 | 0.0044 | 0.0044 | 184 | -0.0029 | -0.0029 |
| 23 | -0.0029 | -0.0029 | 185 | 0.0022 | 0.0022 |
| 24 | -0.0089 | -0.0089 | 186 | 0.0058 | 0.0058 |
| 25 | 0.0029 | 0.0029 | 187 | 0.0029 | 0.0029 |
| 26 | -0.0074 | -0.0074 | 188 | -0.0007 | -0.0007 |
| 27 | 0.0058 | 0.0058 | 189 | 0.0066 | 0.0066 |
| 28 | -0.0074 | -0.0074 | 190 | -0.0096 | -0.0096 |
| 29 | 0.0037 | 0.0037 | 191 | 0.0029 | 0.0029 |
| 30 | -0.0052 | -0.0052 | 192 | -0.0007 | -0.0007 |
| 31 | -0.0029 | -0.0029 | 193 | -0.0015 | -0.0015 |
| 32 | 0.0015 | 0.0015 | 194 | 0.0000 | 0.0000 |
| 33 | -0.0029 | -0.0029 | 195 | 0.0080 | 0.0080 |
| 34 | -0.0044 | -0.0044 | 196 | 0.0058 | 0.0058 |
| 35 | 0.0058 | 0.0058 | 197 | -0.0081 | -0.0081 |
| 36 | 0.0080 | 0.0080 | 198 | 0.0087 | 0.0087 |
| 37 | 0.0000 | 0.0000 | 199 | -0.0089 | -0.0089 |
| 38 | 0.0044 | 0.0044 | 200 | 0.0037 | 0.0037 |

(continued)

| Simulated Deviations of Submodule Capacitances | | | | | |
|---|---|---|---|---|---|
| Submodule Index | Deviation (Figure 1) | Deviation (Figure 2) | Submodule Index | Deviation (Figure 1) | Deviation (Figure 2) |
| 39 | 0.0000 | 0.0000 | 201 | -0.0074 | -0.0074 |
| 40 | 0.0037 | 0.0037 | 202 | -0.0022 | -0.0022 |
| 41 | -0.0022 | -0.0022 | 203 | 0.0037 | 0.0037 |
| 42 | -0.0022 | -0.0022 | 204 | 0.0015 | 0.0015 |
| 43 | -0.0074 | -0.0074 | 205 | 0.0044 | 0.0044 |
| 44 | -0.0044 | -0.0044 | 206 | -0.0015 | -0.0015 |
| 45 | 0.0058 | 0.0058 | 207 | -0.0022 | -0.0022 |
| 46 | -0.0037 | -0.0037 | 208 | -0.0096 | -0.0096 |
| 47 | 0.0044 | 0.0044 | 209 | 0.0007 | 0.0007 |
| 48 | 0.0066 | 0.0066 | 210 | -0.0111 | -0.0111 |
| 49 | -0.0015 | -0.0015 | 211 | 0.0073 | 0.0073 |
| 50 | 0.0044 | 0.0044 | 212 | -0.0089 | -0.0089 |
| 51 | -0.0022 | -0.0022 | 213 | -0.0104 | -0.0104 |
| 52 | -0.0007 | -0.0007 | 214 | -0.0037 | -0.0037 |
| 53 | 0.0007 | 0.0007 | 215 | 0.0080 | 0.0080 |
| 54 | 0.0000 | 0.0000 | 216 | -0.0022 | -0.0022 |
| 55 | 0.0058 | 0.0058 | 217 | 0.0015 | 0.0015 |
| 56 | -0.0022 | -0.0022 | 218 | -0.0052 | -0.0052 |
| 57 | 0.0007 | 0.0007 | 219 | 0.0000 | 0.0000 |
| 58 | 0.0029 | 0.0029 | 220 | 0.0029 | 0.0029 |
| 59 | -0.0059 | -0.0059 | 221 | 0.0051 | 0.0051 |
| 60 | 0.0066 | 0.0066 | 222 | 0.0037 | 0.0037 |
| 61 | 0.0022 | 0.0022 | 223 | 0.0051 | 0.0051 |
| 62 | -0.0007 | -0.0007 | 224 | 0.0029 | 0.0029 |
| 63 | 0.0080 | 0.0080 | 225 | 0.0066 | 0.0066 |
| 64 | 0.0044 | 0.0044 | 226 | 0.0066 | 0.0066 |
| 65 | -0.0022 | -0.0022 | 227 | 0.0058 | 0.0058 |
| 66 | 0.0044 | 0.0044 | 228 | 0.0044 | 0.0044 |
| 67 | 0.0080 | 0.0080 | 229 | 0.0044 | 0.0044 |
| 68 | 0.0029 | 0.0029 | 230 | 0.0058 | 0.0058 |
| 69 | 0.0037 | 0.0037 | 231 | -0.0037 | -0.0037 |
| 70 | 0.0080 | 0.0080 | 232 | 0.0015 | 0.0015 |
| 71 | -0.0022 | -0.0022 | 233 | -0.0044 | -0.0044 |
| 72 | 0.0037 | 0.0037 | 234 | 0.0073 | 0.0073 |
| 73 | -0.0037 | -0.0037 | 235 | 0.0007 | 0.0007 |
| 74 | 0.0007 | 0.0007 | 236 | 0.0058 | 0.0058 |
| 75 | -0.0037 | -0.0037 | 237 | -0.0089 | -0.0089 |
| 76 | -0.0044 | -0.0044 | 238 | 0.0058 | 0.0058 |

(continued)

| Simulated Deviations of Submodule Capacitances | | | | | |
|---|---|---|---|---|---|
| Submodule Index | Deviation (Figure 1) | Deviation (Figure 2) | Submodule Index | Deviation (Figure 1) | Deviation (Figure 2) |
| 77 | 0.0007 | 0.0007 | 239 | -0.0052 | -0.0052 |
| 78 | -0.0044 | -0.0044 | 240 | 0.0058 | 0.0058 |
| 79 | -0.0059 | -0.0059 | 241 | -0.0022 | -0.0022 |
| 80 | -0.0029 | -0.0029 | 242 | -0.0007 | -0.0007 |
| 81 | -0.0007 | -0.0007 | 243 | 0.0022 | 0.0022 |
| 82 | 0.0029 | 0.0029 | 244 | 0.0007 | 0.0007 |
| 83 | -0.0037 | -0.0037 | 245 | 0.0037 | 0.0037 |
| 84 | -0.0022 | -0.0022 | 246 | 0.0029 | 0.0029 |
| 85 | 0.0044 | 0.0044 | 247 | 0.0015 | 0.0015 |
| 86 | 0.0066 | 0.0066 | 248 | 0.0015 | 0.0015 |
| 87 | 0.0015 | 0.0015 | 249 | -0.0081 | -0.0081 |
| 88 | -0.0007 | -0.0007 | 250 | 0.0080 | 0.0080 |
| 89 | 0.0007 | 0.0007 | 251 | -0.0029 | -0.0029 |
| 90 | 0.0073 | 0.0073 | 252 | 0.0080 | 0.0080 |
| 91 | 0.0000 | 0.0000 | 253 | 0.0051 | 0.0051 |
| 92 | 0.0058 | 0.0058 | 254 | -0.0007 | -0.0007 |
| 93 | -0.0015 | -0.0015 | 255 | 0.0022 | 0.0022 |
| 94 | 0.0000 | -0.0526 | 256 | 0.0000 | 0.0000 |
| 95 | 0.0015 | 0.0015 | 257 | 0.0007 | 0.0007 |
| 96 | 0.0000 | 0.0000 | 258 | 0.0051 | 0.0051 |
| 97 | -0.0015 | -0.0015 | 259 | 0.0007 | 0.0007 |
| 98 | 0.0022 | 0.0022 | 260 | 0.0051 | 0.0051 |
| 99 | 0.0029 | 0.0029 | 261 | 0.0058 | 0.0058 |
| 100 | 0.0022 | 0.0022 | 262 | -0.0007 | -0.0007 |
| 101 | 0.0051 | 0.0051 | 263 | 0.0007 | 0.0007 |
| 102 | -0.0007 | -0.0007 | 264 | 0.0094 | 0.0094 |
| 103 | 0.0066 | 0.0066 | 265 | 0.0000 | 0.0000 |
| 104 | 0.0044 | 0.0044 | 266 | 0.0051 | 0.0051 |
| 105 | 0.0000 | 0.0000 | 267 | 0.0007 | 0.0007 |
| 106 | 0.0029 | 0.0029 | 268 | 0.0029 | 0.0029 |
| 107 | 0.0015 | 0.0015 | 269 | -0.0015 | -0.0015 |
| 108 | -0.0044 | -0.0044 | 270 | -0.0037 | -0.0037 |
| 109 | -0.0074 | -0.0074 | 271 | 0.0080 | 0.0080 |
| 110 | 0.0029 | 0.0029 | 272 | 0.0080 | 0.0080 |
| 111 | 0.0000 | 0.0000 | 273 | 0.0007 | 0.0007 |
| 112 | -0.0074 | -0.0074 | 274 | -0.0022 | -0.0022 |
| 113 | -0.0022 | -0.0022 | 275 | 0.0051 | 0.0051 |
| 114 | -0.0059 | -0.0059 | 276 | 0.0007 | 0.0007 |

(continued)

| Simulated Deviations of Submodule Capacitances | | | | | |
|---|---|---|---|---|---|
| Submodule Index | Deviation (Figure 1) | Deviation (Figure 2) | Submodule Index | Deviation (Figure 1) | Deviation (Figure 2) |
| 115 | -0.0052 | -0.0052 | 277 | -0.0015 | -0.0015 |
| 116 | -0.0037 | -0.0037 | 278 | 0.0066 | 0.0066 |
| 117 | -0.0029 | -0.0029 | 279 | -0.0015 | -0.0015 |
| 118 | -0.0044 | -0.0044 | 280 | -0.0029 | -0.0029 |
| 119 | -0.0022 | -0.0022 | 281 | 0.0087 | 0.0087 |
| 120 | 0.0000 | 0.0000 | 282 | 0.0000 | 0.0000 |
| 121 | -0.0037 | -0.0037 | 283 | 0.0058 | 0.0058 |
| 122 | -0.0037 | -0.0037 | 284 | 0.0080 | 0.0080 |
| 123 | -0.0015 | -0.0015 | 285 | 0.0022 | 0.0022 |
| 124 | -0.0015 | -0.0015 | 286 | -0.0029 | -0.0029 |
| 125 | -0.0066 | -0.0066 | 287 | -0.0015 | -0.0015 |
| 126 | -0.0044 | -0.0044 | 288 | 0.0037 | 0.0037 |
| 127 | -0.0037 | -0.0037 | 289 | -0.0029 | -0.0029 |
| 128 | -0.0044 | -0.0044 | 290 | 0.0051 | 0.0051 |
| 129 | -0.0059 | -0.0059 | 291 | 0.0044 | 0.0044 |
| 130 | 0.0130 | 0.0130 | 292 | 0.0102 | 0.0102 |
| 131 | -0.0022 | -0.0022 | 293 | 0.0037 | 0.0037 |
| 132 | 0.0022 | 0.0022 | 294 | 0.0044 | 0.0044 |
| 133 | 0.0007 | 0.0007 | 295 | 0.0058 | 0.0058 |
| 134 | 0.0058 | 0.0058 | 296 | 0.0044 | 0.0044 |
| 135 | 0.0007 | 0.0007 | 297 | 0.0029 | 0.0029 |
| 136 | -0.0007 | -0.0007 | 298 | 0.0051 | 0.0051 |
| 137 | -0.0007 | -0.0007 | 299 | 0.0044 | 0.0044 |
| 138 | -0.0074 | -0.0074 | 300 | 0.0109 | 0.0109 |
| 139 | -0.0111 | -0.0111 | 301 | 0.0015 | 0.0015 |
| 140 | 0.0007 | 0.0007 | 302 | 0.0094 | 0.0094 |
| 141 | 0.0029 | 0.0029 | 303 | 0.0109 | 0.0109 |
| 142 | -0.0029 | -0.0029 | 304 | 0.0044 | 0.0044 |
| 143 | -0.0022 | -0.0022 | 305 | 0.0051 | 0.0051 |
| 144 | 0.0000 | 0.0000 | 306 | 0.0037 | 0.0037 |
| 145 | -0.0037 | -0.0037 | 307 | -0.0029 | -0.0029 |
| 146 | 0.0015 | 0.0015 | 308 | 0.0029 | 0.0029 |
| 147 | 0.0007 | 0.0007 | 309 | 0.0007 | 0.0007 |
| 148 | -0.0022 | -0.0022 | 310 | 0.0007 | 0.0007 |
| 149 | -0.0074 | -0.0074 | 311 | 0.0058 | 0.0058 |
| 150 | -0.0052 | -0.0052 | 312 | -0.0022 | -0.0022 |
| 151 | -0.0044 | -0.0044 | 313 | 0.0029 | 0.0029 |
| 152 | -0.0044 | -0.0044 | 314 | 0.0066 | 0.0066 |

(continued)

| Simulated Deviations of Submodule Capacitances | | | | | |
|---|---|---|---|---|---|
| Submodule Index | Deviation (Figure 1) | Deviation (Figure 2) | Submodule Index | Deviation (Figure 1) | Deviation (Figure 2) |
| 153 | -0.0022 | -0.0022 | 315 | 0.0000 | 0.0000 |
| 154 | 0.0000 | 0.0000 | 316 | 0.0029 | 0.0029 |
| 155 | -0.0052 | -0.0052 | 317 | 0.0066 | 0.0066 |
| 156 | -0.0037 | -0.0037 | 318 | 0.0044 | 0.0044 |
| 157 | -0.0052 | -0.0052 | 319 | 0.0044 | 0.0044 |
| 158 | -0.0022 | -0.0022 | 320 | 0.0029 | 0.0029 |
| 159 | -0.0037 | -0.0037 | 321 | 0.0058 | 0.0058 |
| 160 | 0.0037 | 0.0037 | 322 | 0.0037 | 0.0037 |
| 161 | -0.0022 | -0.0022 | 323 | 0.0037 | 0.0037 |
| 162 | -0.0052 | -0.0052 | 324 | 0.0029 | 0.0029 |
| | | | 325 | 0.0022 | 0.0022 |

**Claims**

1. A method of determining submodule capacitor degradation comprising the steps of:

    determining voltage change of at least one submodule capacitor during a control cycle whilst the at least one submodule is switched into a valve circuit and assigning the voltage change as $dV_{vsm}$;
    determining average voltage change across all in-circuit submodules during said control cycle and assigning the average voltage change as $dV_{average}$;
    determining relative capacitance of all in-circuit submodules by comparing $dV_{vsm}$ to the $dV_{average}$ of all in-circuit submodules.

2. The method according to claim 1, further comprising the step of

    determining relative capacitance deviation of all in-circuit submodules to quantify how much the relative capacitance of each in-circuit submodule deviates from the average by comparing the in-circuit submodule voltage change $dV_{vsm}$ to the average voltage change $dV_{average}$ across all in-circuit submodules; and optionally comparing the determined relative capacitance deviation against a pre-defined threshold value to identify degraded in-circuit submodules;
    or comparing the determined relative capacitance against a pre-defined threshold value to identify degraded in-circuit submodules.

3. The method according to any of the preceding claims, wherein the monitored submodules are part of either a VSC HVDC, MVDC, STATCOM system or any other modular multilevel converter systems, wherein each of the steps is performed in real-time, i.e. whilst the system is operating, or performed off-line based on data collected while the system was operating, and or wherein the step of determining capacitance deviation is as a percentage, and or wherein the step of measuring voltage change $dV_{vsm}$ of at least one submodule capacitor during a control cycle comprises $V_{vsm}(t_2) - V_{vsm}(t_1)$, wherein $V_{vsm}(t_1)$ and $V_{vsm}(t_2)$ are the voltage readings at the beginning and end of the control cycle, respectively.

4. The method according to any of the preceding claims, wherein the step of determining average voltage change $dV_{average}$ across all in-circuit submodules comprises $\frac{1}{N}\sum_{i=1}^{N} dV_{vsm,i}$ wherein

    $N$ is the number of submodules in the circuit during the control cycle, and
    $dV_{vsm,i}$ is the voltage change for the $i$ th submodule during the control cycle.

5. The method according to any of the preceding claims, wherein the step of determining relative capacitance of all in-circuit submodules comprises

$$\frac{C_{vsm}}{C_{average}} = \frac{dV_{average}}{dV_{vsm}}$$

wherein:

$C_{vsm}$ is the capacitance of the in-circuit submodule,
$C_{average}$ is the average capacitance of all in-circuit submodules.
$dV_{vsm}$ is the voltage change of the in-circuit submodule during the control cycle, and
$dV_{average}$ is the average voltage change of all in-circuit submodules during the control cycle.

6. The method according to any of the preceding claims, wherein the step of determining capacitance deviation of all in-circuit submodules comprises

$$\left(\frac{dV_{average}}{dV_{vsm}} - 1\right) \times 100\%$$

or

$$\left(1 - \frac{dV_{vsm}}{dV_{average}}\right) \times 100\%$$

7. The method according to any of the preceding claims, further comprising storing the determined values for historical tracking.

8. The method according to any of the preceding claims, further comprising the step of applying digital filtering to $dV_{vsm}$ and or $dV_{average}$.

9. The method according to claim 8, wherein the filter is applied as follows to achieve more accurate relative capacitance determination:

$$Filter\left(\frac{dV_{average}}{dV_{vsm}}\right)$$

or

$$\frac{Filter\left(dV_{average}\right)}{Filter\left(dV_{vsm}\right)}$$

10. The method according to any of the preceding claims, further comprising the step of applying digital filtering to capacitance deviation as follows:

$$\left(\frac{Filter\left(dV_{average}\right)}{Filter\left(dV_{vsm}\right)} - 1\right) \times 100\%$$

or

$$\left(1 - \frac{Filter\ (dV_{vsm})}{Filter\ (dV_{average})}\right) \times 100\%$$

or

$$\left(Filter\left(\frac{dV_{average}}{dV_{vsm}}\right) - 1\right) \times 100\%$$

or

$$\left(1 - Filter\left(\frac{dV_{vsm}}{dV_{average}}\right)\right) \times 100\%$$

11. The method according to any of claims 8 to 10, wherein when a submodule is not in the valve circuit during a control cycle the filter operation is paused for the submodule for that cycle.

12. The method according to any of the preceding claims, wherein control cycles wherein the number of in-circuit submodules is below a threshold value are excluded from the analysis, and or wherein control cycles wherein $dV_{average}$ does not exceed a threshold value are excluded from the analysis.

13. The method according to any of the preceding claims, wherein when an in-circuit submodule voltage readings are unreliable during a control cycle, the submodule is excluded from submodule voltage change determination and average voltage change determination for the control cycle, and the filter operation is paused for the submodule for the control cycle, and or wherein the following additional steps are performed to determine the absolute submodule capacitance:

    (A) measure the actual capacitance of one or more submodules during maintenance,
    (B) calculate the absolute capacitance for all submodules using their relative capacitances and the known capacitance value from step (A).

14. The method according to any of the preceding claims, further comprising the step or steps of;

    flagging at least one submodule capacitor; and or
    triggering one or more alert to notify an operator that action is required; and or
    scheduling maintenance of at least one submodule capacitor; and or
    reducing energy supplied to at least one submodule.

15. A system for executing the method of any of the preceding claims, the system comprising:

    at least one submodule capacitor and associated valve circuit,
    a voltage sensor configured to measure the voltage changes or derive the voltage changes by measuring the voltage at each control cycle for the at least one submodule capacitor;
    a control system configured to switch the at least one submodule into the valve circuit;
    a processor configured to execute the method steps of determining average voltage change, and relative capacitance; and
    wherein the valve circuit comprises the at least one submodule capacitor and is configured to switch the at least one submodule capacitor into and out of said valve circuit as managed by the control system.

FIGURE 1

FIGURE 2

EUROPEAN SEARCH REPORT

Application Number

EP 24 21 7928

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2023/165680 A1 (HITACHI ENERGY SWITZERLAND AG [CH]) 7 September 2023 (2023-09-07) * page 9, line 26 - page 18, line 27; figures 1-5 * | 1-15 | INV. G01R27/26 G01R31/64 ADD. G01R31/40 |
| A | ZHOU WEIHAO ET AL: "A Statistical Submodule Open-circuit Failure Diagnosis Method for MMCs Enabling Failure Detection, Localization and Classification", 2019 IEEE APPLIED POWER ELECTRONICS CONFERENCE AND EXPOSITION (APEC), IEEE, 17 March 2019 (2019-03-17), pages 2356-2361, XP033555953, DOI: 10.1109/APEC.2019.8721882 [retrieved on 2019-05-24] * the whole document * | 1-15 | |
| A | US 2016/313387 A1 (SCHWEIZER MARIO [CH] ET AL) 27 October 2016 (2016-10-27) * paragraph [0035] - paragraph [0074]; figures 1-4 * | 1-15 | TECHNICAL FIELDS SEARCHED (IPC) G01R H02M |
| A | DENG FUJIN ET AL: "Capacitor monitoring for modular multilevel converters", IECON 2017 - 43RD ANNUAL CONFERENCE OF THE IEEE INDUSTRIAL ELECTRONICS SOCIETY, IEEE, 29 October 2017 (2017-10-29), pages 934-939, XP033279666, DOI: 10.1109/IECON.2017.8216161 [retrieved on 2017-12-15] * the whole document * | 1-15 | |

The present search report has been drawn up for all claims

| Place of search | Date of completion of the search | Examiner |
|---|---|---|
| Munich | 16 May 2025 | Hijazi, Ali |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 21 7928

This annex lists the patent family members relating to the patent documents cited in the above-mentioned European search report.
The members are as contained in the European Patent Office EDP file on
The European Patent Office is in no way liable for these particulars which are merely given for the purpose of information.

16-05-2025

| Patent document cited in search report | Publication date | Patent family member(s) | | Publication date |
|---|---|---|---|---|
| WO 2023165680 A1 | 07-09-2023 | CN | 118743128 A | 01-10-2024 |
| | | EP | 4487437 A1 | 08-01-2025 |
| | | WO | 2023165680 A1 | 07-09-2023 |
| US 2016313387 A1 | 27-10-2016 | CN | 105830326 A | 03-08-2016 |
| | | DK | 2887526 T3 | 24-06-2019 |
| | | EP | 2887526 A1 | 24-06-2015 |
| | | US | 2016313387 A1 | 27-10-2016 |
| | | WO | 2015090892 A1 | 25-06-2015 |

EPO FORM P0459

For more details about this annex : see Official Journal of the European Patent Office, No. 12/82